# EUROPEAN PATENT APPLICATION

(11) **EP 1 253 601 A2**
(43) Date of publication of application: **30.10.2002**
(21) Application number: 02252879.8
(22) Date of filing: 24.04.2002
(51) Int. Cl.: G21K 1/06, G02B 7/182, G03F 7/20

(54) **Methods and devices for holding a mirror for use in X-ray optical systems**

(30) Priority: 24.04.2001 JP 2001125562
(71) Applicant: NIKON CORPORATION, Tokyo 100-0005 (JP)
(72) Inventor: Shiraishi, Masayuki, Saitama-ken (JP)
(74) Representative: Meddle, Alan Leonard

(57) **Abstract**

Methods and devices are disclosed for use in holding mirrors as used in any of various X-ray optical systems. In this context, "X-ray" encompasses the so-called "soft X-ray" or "EUV" wavelengths. The X-ray optical systems can be used, for example, in EUV microlithography systems. A fluid cavity (e.g., an elastic toroidal ring) extends around the circumference of an X-ray mirror. The cavity defines a lumen that is filled with a fluid. The fluid can be static or flowing, and can be a gas or liquid. Holding members are disposed evenly spaced around the circumference of the cavity. Thus, any stress imparted to the mirror by holding is distributed evenly around the circumference of the mirror.

## Description

### Field

This disclosure pertains to X-ray and soft X-ray (extreme ultraviolet or "EUV") optical systems employing reflective mirrors. Such optical systems are used, for example, in telescopes and microlithography apparatus and methods employing X-rays or soft X-rays. More specifically, the disclosure pertains to methods and devices for holding a reflective mirror as used in such an optical system, and to optical systems comprising one or more mirrors held by a subject device.

### Background

Conventional mirror-holding devices and methods are described below in the context of, by way of example, an extreme UV (EUV) microlithography apparatus. In a general sense as used herein, the term "X-ray" encompasses both conventional "hard" X-ray wavelengths (0.1 to 1000 Å) as well as the so-called "soft" X-ray wavelengths such as the particularly useful range of 11-15 nm, also termed "extreme ultraviolet" or "EUV" wavelengths.

As the intricacy and degree of miniaturization of microelectronic devices has continued to increase, projection microlithography technologies have been developed recently that offer prospects of increased resolution of projected patterns than currently obtainable using conventional "optical" microlithography (i.e., microlithography performed using an UV beam). Certain of these so-called "next-generation" microlithography technologies utilize exposure wavelengths that are substantially shorter than vacuum-ultraviolet light. For example, use of soft X-ray (EUV) wavelengths (about 11 to 15 nm) is the subject of substantial development work being conducted currently. A conventional EUV microlithography system includes an EUV-beam source, an illumination-optical system, a reticle stage, a projection-optical system, and a wafer (substrate) stage.

Various types of EUV sources have been investigated such as a synchrotron (in which the EUV beam and other X-ray wavelengths are generated by accelerated electrons), laser-plasma EUV sources, and dense-plasma-focus (DPF) EUV sources. The illumination-optical system typically comprises a grazing-incidence mirror, one or more multi-layer mirrors, and a wavelength-selecting mirror or wavelength filter that reflects or transmits, respectively, only a certain specified EUV wavelength for irradiating the reticle.

The reticle (also termed a "mask") is the optical element that defines the pattern to be transferred to the substrate. In EUV and other X-ray systems, reflective reticles currently are the most suitable for use with such short wavelengths. A pattern is defined on a reflective reticle by selectively applying regions (corresponding to pattern elements) of low-EUV-reflectivity on a multi-layer EUV-reflective substrate. The regions of low-EUV-reflectivity are formed by patterning and electroplating such a layer on the multi-layer EUV-reflective substrate. The multi-layer substrate is prepared by applying alternating layers of materials (e.g., molybdenum (Mo) and silicon (Si)) on a substrate that collectively confer high EUV-reflectivity to the surface of the substrate.

The EUV radiation reflected from the reflective portions of the pattern on the reticle pass through the projection-optical system to the lithographic substrate ("wafer"). The projection-optical system comprises several multi-layer EUV-reflective mirrors that collectively pass a patterned beam, produced by reflection of the illumination beam from the reticle and carrying an aerial image of the pattern portion in the irradiated portion of the reticle, to the wafer so as to form a corresponding image on the wafer. So as to be imprintable with the image, the surface of the wafer is coated with a substance, termed a "resist," that is sensitive to exposure by the patterned beam. Since EUV radiation is absorbed (and hence damped) by the atmosphere, the entire optical path from source to wafer is disposed inside a vacuum chamber maintained at a vacuum of around 10⁻⁵ Torr.

As noted above, a typical multi-layer mirror comprises a substrate material that maintains its shape very accurately, has extremely low surface roughness, and is easily worked. Exemplary substrate materials are quartz and low-thermal-expansion glass such as "Zerodur" (made by Schott). The multi-layers typically are alternating very thin layers of Mo and Si applied to the surface of the substrate in a laminar manner. The thickness of individual layers is selected carefully such that the multi-layer structure on the substrate surface matches the phases of the reflected light at the boundaries of each respective film layer, so as to yield high reflectivity to the particular wavelength of incident EUV radiation.

Extremely high accuracy and precision of imaging performance must be provided by an EUV microlithography system. Hence, extremely rigorous manufacturing specifications must be met when fabricating each multi-layer mirror. For example, in a multi-layer mirror comprising alternating layers of Mo and Si, the rms value of wavefront aberration produced by the mirror must be no greater than 1/14 of the incident EUV wavelength (λ). This represents an error of approximately 1 nm or less, in order to obtain diffraction-limit imaging performance with high reflectivity using EUV radiation of about λ = 13 nm. Since a typical projection-optical system includes four to eight multi-layer mirrors, extremely high fabrication accuracy and precision of each mirror, as well as accuracy and precision of assembly of the projection-optical system, are required. As a result, the allowable rms value for each multi-layer mirror is 0.20 to 0.25 nm or less.

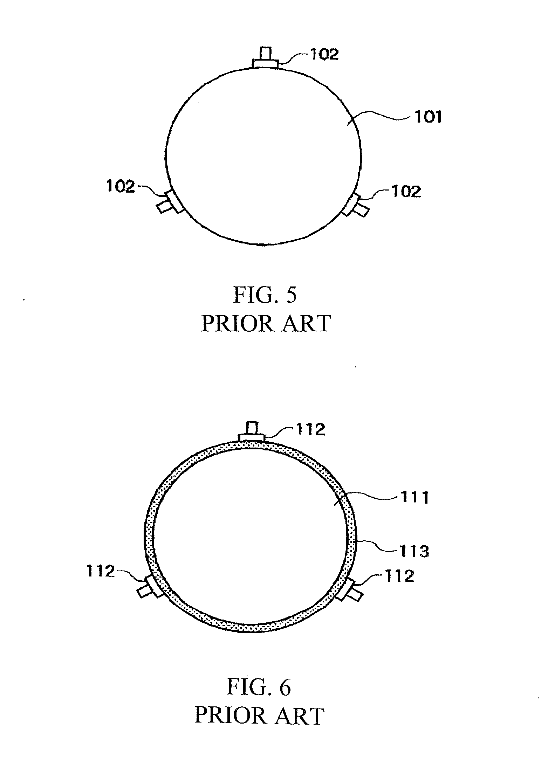

In view of the above, careful attention must be directed to the manner in which each multi-layer mirror is held in the projection-optical system. One type of conventional mirror-holding device is shown in FIG. 5, in association with a disc-shaped mirror 101. The mirror 101 is held by three holding members 102 placed equi-distantly around the circumference of the mirror 101. Each holding member 102 is made of a material such as stainless steel or Invar. Normally, the mirror 101 is held in a vertical orientation by the holding members 102.

Whenever a mirror 101 (even though manufactured to have a surface that is within specifications) is held in the manner shown in FIG. 5, since the mirror is point-supported with stress due to the holding members 102 being concentrated at specific loci on the sides or back of the mirror. In response to such stress, irregular and asymmetrical deformations of the mirror develop in the vicinity of the holding members 102. These asymmetrical deformations produce distortions in the reflective surface of the mirror. The resulting aberrations degrade the optical performance of the mirror. These effects are difficult to compensate for, even by making optical adjustments elsewhere in the system.

Another conventional manner of holding a multi-layer mirror 11 is shown in FIG. 6, in which a disc-shaped mirror 111 is held by a circumferential elastic ring 113 made of Viton rubber or the like. The elastic ring 113 is mounted to three holding members 112 disposed equi-angularly around the ring 113. The holding members 112 are made of a material such as stainless steel or Invar. Normally, the mirror 111 is mounted in a vertical orientation in this manner.

In the scheme shown in FIG. 6, mirror stress is reduced by sandwiching the elastic material of the ring 113 between the mirror 111 and the holding members 112. However, irregular deformations of the ring 113 nevertheless arise in the vicinity of the holding members 112. These deformations are conducted to the mirror and cause corresponding changes to the reflective surface of the mirror 111.

Even the finest multi-layer mirror is not 100-percent reflective to incident EUV radiation (the maximum reflectivity achieved to date is about 70%). Hence, since some of the incident EUV radiation is absorbed by the mirror, the resulting local heating of the mirror causes thermal expansion, and hence deformation, of the mirror. In a projection-optical system of an EUV microlithography system, a thermally deformed mirror produces aberrations in the projection-optical system, which decreases the accuracy of lithographic exposure.

In view of the foregoing, there is a need for improved methods and devices for holding mirrors as used in X-ray optical systems.

### Summary

In view of the shortcomings of conventional mirror-mounting methods and devices as summarized above, the present invention provides, *inter alia,* X-ray optical systems (including "hard" and "soft" X-ray optical systems) in which the mirrors are held in a manner that substantially reduces mirror deformation and aberrations. The present invention also provides mirror-holding devices and methods that achieve such ends.

According to a first aspect of the invention, methods are provided for holding an optical element in an optical system. An embodiment of such a method comprises providing a fluid chamber containing a fluid and extending peripherally around the optical element. The optical element is mounted to a holding member such that the fluid chamber is situated between the optical element and the holding member. For example, the optical element can be circular, thereby having a circular edge. In such an instance the fluid chamber is arranged so as to extend circumferentially around the edge of the optical element. The fluid can be static or circulating (or generally flowing), and can be a gas or a liquid. The optical element can be a reflective mirror, such as an X-ray reflective mirror. By mounting the optical element in this manner, the optical element is supported by fluid pressure, which tends to be distributed evenly in the fluid chamber. Thus, localized deformation of the optical element that otherwise would arise from the holding member is avoided.

The fluid chamber can be elastomeric, such as a toroidal-shaped elastomeric tube extending around the periphery of the optical element. Alternatively, the fluid chamber can be defined as a groove in a peripheral edge of the optical element. In this instance, a ring is extended circumferentially around the peripheral edge of the optical element, wherein the ring has a width sufficient to cover the groove. The ring is sealed to the groove, desirably using elastomeric seals.

If the fluid is flowing or circulating, it is desirable for certain applications that the temperature of the fluid be controlled as the fluid flows through the fluid chamber. For example, if the optical element is an X-ray reflective mirror, a portion of the energy of an X-ray beam incident on the mirror is absorbed by the mirror. The absorbed energy heats the mirror and can cause thermal deformation of the mirror. Circulating the fluid in the fluid chamber facilitates dissipation of heat from the mirror, thereby reducing thermal deformation of the mirror.

According to another aspect of the invention, devices are provided for holding an optical element in an optical system. An embodiment of such a device comprises a fluid chamber extending peripherally around the optical element, with a fluid being disposed in the fluid chamber. The optical element is mounted to a holding member of the optical system such that the fluid chamber is situated between the optical element and the holding member.

As noted above, the optical element can be circular, thereby having a circular edge. In such an instance the fluid chamber desirably extends circumferentially around the edge of the optical element. The fluid can be static or circulating (or generally flowing), and can be a gas or a liquid. The optical element can be a reflective mirror, such as an X-ray reflective mirror.

The fluid chamber can be elastomeric, as summarized above. Alternatively, the fluid chamber can be defined as a groove in a peripheral edge of the optical element, and includes a ring extending circumferentially around the peripheral edge of the optical element. The ring has a width sufficient to cover the groove, and is sealed to the groove desirably using elastomeric seals.

If the fluid is flowing or circulating, the device can include a heat exchanger or the like for controlling the temperature of the fluid as the fluid flows through the fluid chamber.

Another aspect of the invention is directed to combination of an X-ray reflective mirror configured for use as an optical element in an X-ray optical system, and device (as summarized above) for holding the X-ray reflective mirror.

Yet another aspect of the invention is directed to an optical element mounted to a holding member. In an embodiment, a fluid chamber is situated between the optical element and the holding member, wherein a fluid is disposed in the fluid chamber.

As noted above, the optical element can be circular, thereby having a circular edge, wherein the fluid chamber can be arranged so as to extend circumferentially around the edge of the optical element. The fluid can be static or circulating (or generally flowing), and can be a gas or a liquid. The optical element can be a reflective mirror, such as an X-ray reflective mirror.

The fluid chamber can be elastomeric, as summarized above, or defined as a groove in a peripheral edge of the optical element, wherein a ring is extended circumferentially around the peripheral edge of the optical element. The ring has a width sufficient to cover the groove, and is sealed to the groove, desirably using . elastomeric seals.

Yet another aspect of the invention is directed to microlithography systems. An embodiment of such a system comprises a beam source that generates a lithographic energy beam, an illumination-optical system, a projection-optical system, and a chamber containing at least the illumination- and projection-optical systems. The illumination-optical system is situated downstream of the beam source and is configured to guide the energy beam from the beam source to a pattern-defining reticle. The illumination-optical system comprises at least one respective optical element and a holding member for the optical element. The projection-optical system is situated downstream of the reticle and is configured to guide the energy beam from the reticle to a sensitive substrate so as to imprint the pattern on the sensitive substrate. The projection-optical system comprises at least one respective optical element and a holding member for the optical element. The illumination-optical system further comprises a fluid chamber situated between the respective holding member and the respective optical element. Similarly, the projection-optical system further comprises a fluid chamber situated between the respective holding member and the respective optical element. A fluid is situated in each of the fluid chambers. The microlithography system can be configured to utilize an X-ray beam as the energy beam, wherein the optical elements are respective mirrors reflective to the energy beam.

The foregoing and additional features and advantages of the invention will be more readily apparent from the following detailed description, which proceeds with reference to the accompanying drawings.

### Brief Description of the Drawings

The invention is set forth below in the context of multiple representative embodiments that are not intended to be limiting in any way.

FIGS. 1(A)-1(B) depict a mirror-holding device and method according to a first representative embodiment, wherein FIG. 1(A) is a plan view, and FIG. 1(B) is a median sagittal section along the line A-A in FIG. 1(A).

FIG. 2 is a transverse section showing a mirror-holding device and method according to a second representative embodiment.

FIGS. 3(A)-3(B) depict a mirror-holding device and method according to a third representative embodiment, wherein FIG. 3(A) is a plan view, and FIG. 3(B) is a median sagittal section along the line B-B in FIG. 3(A).

FIG. 4 is a median sagittal section showing a mirror-holding device and method according to a fourth representative embodiment.

FIG. 5 is a plan view of a first conventional method for holding a mirror.

FIG. 6 is a plan view of a second conventional method for holding a mirror.

FIG. 7 is an elevational view showing certain features of an EUV microlithography system including mirrors being held according to any of the various embodiments of this invention.

### Detailed Description

The invention is described below in the context of multiple representative embodiments that are not intended to be limiting in any way. In the descriptions of the embodiments, the mirror is described, by way of example, as an EUV multi-layer mirror configured for use in an EUV (soft X-ray) microlithography system.

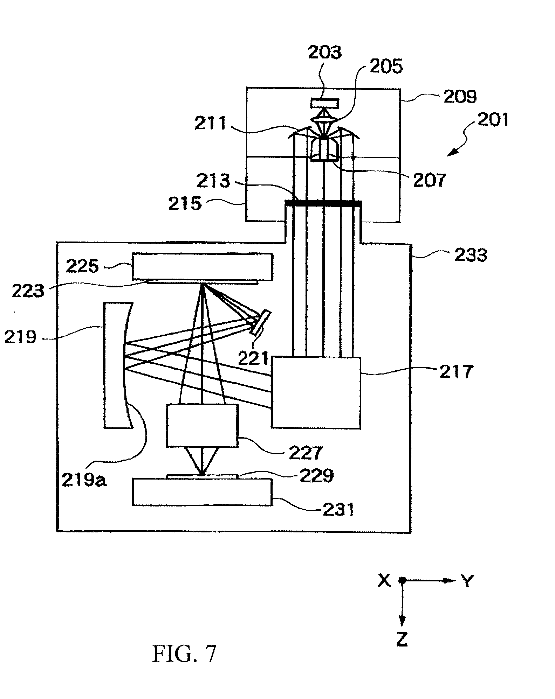

First, an overview of an exemplary EUV "reducing" projection-exposure system, as used for EUV microlithography, is provided. The exemplary system 201 is shown in FIG. 7. The system 201 projects an image of a pattern, defined by a reticle 223, onto the surface of a lithographic substrate ("wafer") 229 using an EUV beam. The image as projected is "reduced" (demagnified).

The EUV beam in this system has a wavelength of about 13 nm, and is produced by an EUV source situated at the optically most upstream portion of the system. The EUV source produces the EUV by interaction of a laser beam with a substance that, when irradiated by the laser beam, forms a plasma that produces EUV radiation. The laser beam is produced by a laser light source 203. The laser light produced by the source 203 has a wavelength typically in the range of infrared to visible. For example, the laser source 203 can be a YAG laser or excimer laser. The laser light emitted from the laser source 203 is focused by a condenser 205 onto a locus in a laser-plasma source 207. At the laser-plasma source 207 the laser beam interacts with a substance under conditions that produce a plasma from the interaction. The plasma produces EUV radiation having a wavelength in the vicinity of 13 nm.

In the laser-plasma source 207 the plasma-producing substance (e.g., xenon gas) is discharged from a nozzle (not shown) in a manner well-known in the art. As the xenon gas is discharged from the nozzle the gas is exposed in the laser-plasma source 207 to the high-intensity laser light focused by the condenser 205. As a result of such intense irradiation, the molecules of xenon gas are heated and excited sufficiently to a plasma state. Accompanying a subsequent relaxation of the molecules to a lower-potential state, the molecules emit EUV light. Since EUV light has low transmissivity in air, its light path is encased in a chamber (vacuum chamber) 209. Since debris normally is produced from the nozzle discharging the xenon gas, the chamber 209 must be separate from other chambers of the EUV microlithography system 201.

A paraboloid mirror 211 having a multi-layer Mo/Si coating is situated relative to the laser-plasma source 207 such that EUV radiation emitted from the laser-plasma source 207 is reflected by the paraboloid mirror 211. Actually, only EUV radiation having a wavelength in the vicinity of 13 nm is reflected from the mirror 211 as a collimated flux in a downstream direction.

The EUV radiation from the mirror 211 is incident on a filter 213 that is opaque to visible light and transmissive to the desired wavelength of EUV radiation. The filter 213 typically is made from beryllium, 0.15 µm thick. The area around the filter 213 is enclosed inside a chamber 215.

An exposure chamber 233 is situated downstream of the filter 213. An illumination-optical system 217 is disposed inside the exposure chamber 233 downstream of the filter 213. The illumination-optical system 217 comprises a condenser mirror and a fly-eye mirror, for example. Thus, EUV radiation from the filter 213 is shaped into a uniform collimated beam having a circular transverse section across which the illumination intensity is uniform. The illumination-optical system 217 directs the EUV flux toward the left in the figure.

An EUV-reflective mirror 219 is situated to the left of the illumination-optical system 217 in the figure. The mirror 219 includes a reflective surface 219a that typically is concave and circular in profile. The mirror 219 is held in a vertical posture, in the figure, by holding members, as discussed below. A bending mirror 221 is disposed at an angle, relative to the mirror 219, to the right of the mirror 219 in the figure. A reflective reticle 223 is situated such that EUV radiation reflected from the bending mirror 221 is incident on the reticle 223. Note that the reticle 223 is oriented such that its reflective surface faces downward in the figure. Thus, EUV radiation emitted from the illumination-optical system 217 is reflected and focused by the mirrors 219 and 221 onto the reflective surface of the reticle 223.

Each of the mirrors 219 and 221 has a respective reflective surface formed on a quartz substrate. For example, the surface of the quartz substrate on which the reflective surface of the mirror 219 is formed is machined with extremely high accuracy. Multi-layer films of Mo and Si are applied to the machined surface to make the surface reflective to EUV radiation. The multi-layer films 219a are formed in a manner conferring high reflectivity to incident EUV radiation having a wavelength of 13 nm. Other materials that can be used for forming multi-layer films reflective to EUV radiation in the wavelength range of 10 to 15 nm include ruthenium (Ru), rhodium (Rh), beryllium (Be), and B₄C (carbon tetraboride).

A multi-layer EUV-reflective film also is formed on the reflective surface of the reticle 223. Pattern elements of the pattern defined by the reticle 223 are formed on the reflective film. The reticle 223 is mounted on a reticle stage 225 that is movable in at least the Y-direction. As noted above, the entire pattern as defined on the reticle 223 normally cannot be exposed in one shot. Hence, the pattern as defined on the reticle 223 is divided into multiple regions each defining a respective portion of the pattern. EUV radiation reflected by the bending mirror 221 is irradiated sequentially onto the individual regions of the reticle 223.

Downstream of the reticle 223 are a projection-optical system 227 and the wafer 229. The projection-optical system 227 comprises several EUV-reflective mirrors that collectively focus an image of the illuminated portion of the reticle 223 onto the surface of the wafer 229. As noted above, the image as formed on the wafer is "reduced" or "demagnified" by a "demagnification factor" (e.g., 1/4). The wafer 229 is mounted by suction, electrostatic attraction, or the like onto a wafer stage 231 that is movable in the X-, Y-, and Z-directions.

During exposure EUV light is directed by the illumination-optical system 217 onto the patterned surface of the reticle 223. Meanwhile, the reticle 223 and wafer 229 are scanned synchronously relative to the projection-optical system 227 at a specified velocity ratio determined by the demagnification ratio of the projection-optical system. Thus, all of the pattern elements defined on the surface of the reticle 223 are transferred to respective locations on the wafer 229 in a step-and-scan manner. Currently, a 25×25 mm-square chip can be exposed on the wafer 229 with a line-space resolution of 0.07 µm (in the resist on the wafer).

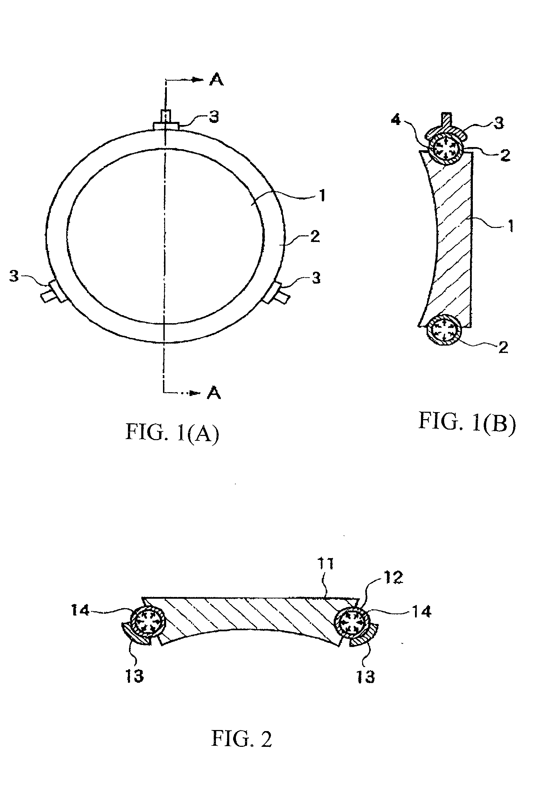

A first representative embodiment of a mirror-holding device and method is depicted in FIGS. 1(A)-1(B), wherein FIG. 1(A) is a plan view and FIG. 1(B) is a median sagittal section along the line A-A in FIG. 1(A). The mirror-holding device shown in FIGS. 1(A)-1(B) is especially suitable for holding any of the mirrors in the illumination-optical system 217 and the projection-optical system 227, as well as the mirrors 219 and 221, shown in FIG 1.

By way of example, the mirror 1 shown in FIG. 1(A) is disc-shaped. The mirror 1 has a reflective surface (left side of the mirror shown in FIG. 1(B)) that is concave, with a surface that is polished and formed, with extremely high accuracy, with an EUV-reflective multi-layer coating. A hollow elastic ring 2 extends around the circumference of the mirror 1. The lumen in the elastic ring 2 is filled with a static fluid 4. The static fluid 4 can be a liquid (e.g., water or alcohol) or a gas (e.g., argon, helium, or nitrogen). Holding members 3 (made, e.g., from stainless steel or Invar) are disposed at three respective loci evenly spaced around the circumference of the elastic ring 2. The mirror 1 (with surrounding ring 2) can be held in a vertical posture by the holding members 3.

The static fluid 4 inside the lumen of the ring 2 acts as a stress-buffer that allows the mirror 1 to be supported with nearly uniform force applied to the mirror around the circumference of the mirror. This uniform force is maintained even if the holding members 3 are deformed in an uneven manner.

A second representative embodiment of a mirror-holding device and method is depicted in FIG. 2 in transverse section. The mirror-holding device shown in FIG. 2 is especially suitable for holding any of the mirrors in the illumination-optical system 217 and the projection-optical system 227, as well as the mirrors 219 and 221, shown in FIG 1.

By way of example, the mirror 11 shown in FIG. 2 is disc-shaped. The mirror 11 has a reflective surface (bottom surface of the mirror shown in FIG. 2) that is concave, with a surface that is polished and formed, with extremely high accuracy, with an EUV-reflective multi-layer coating. A hollow elastic ring 12 extends around the circumference of the mirror 11. The lumen in the elastic ring 12 is filled with a static fluid 14. The static fluid 14 can be a liquid (e.g., water or alcohol) or a gas (e.g., argon, helium, or nitrogen). Holding members 13 (made, e.g., from stainless steel or Invar) are disposed at three respective loci evenly spaced around the circumference of the elastic ring 12.

As in the first representative embodiment, the static fluid 14 inside the lumen of the ring 12 in the second representative embodiment acts as a stress-buffer that allows the mirror 11 to be supported with nearly uniform force applied to the mirror around the circumference of the mirror. This uniform force is maintained even if the holding members 13 are deformed in an uneven manner. The mirror 11 (with surrounding ring 12) can be held in a vertical posture or any other posture by the holding members 13.

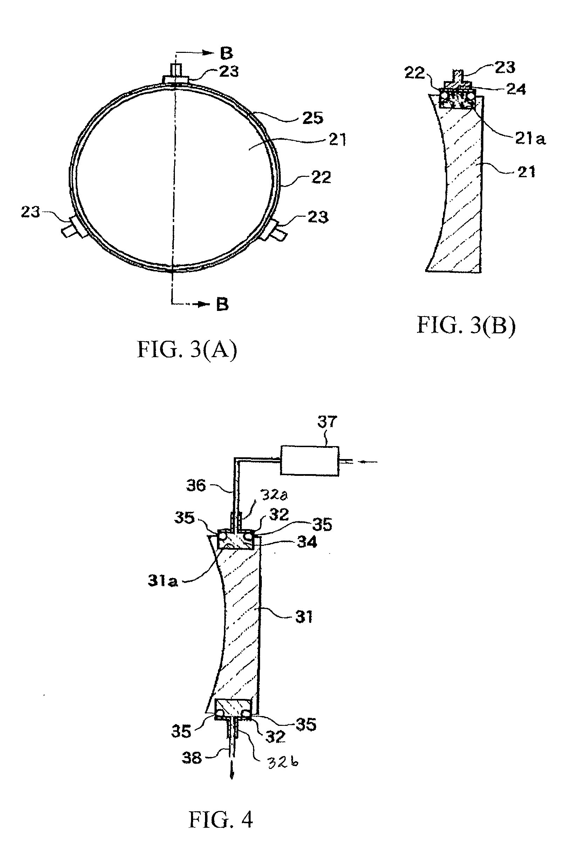

A third representative embodiment of a mirror-holding device and method is depicted in FIGS. 3(A)-3(B), wherein FIG. 3(A) is a plan view and FIG. 3(B) is a median sagittal section along the line B-B in FIG. 3(A). The mirror-holding device shown in FIGS. 3(A)-3(B) is especially suitable for holding any of the mirrors in the illumination-optical system 217 and the projection-optical system 227, as well as the mirrors 219 and 221, shown in FIG 1.

By way of example, the mirror 21 shown in FIG. 3(A) is disc-shaped. The mirror 21 has a reflective surface (left-facing surface of the mirror shown in FIG. 3(B)) that is concave, with a surface that is polished and formed, with extremely high accuracy, with an EUV-reflective multi-layer coating. Defined in the circumferential edge of the mirror 21 is a groove 21a, having a defined depth, extending around the circumference of the mirror 21. A ring 22 of metal or the like, having a defined thickness and having a width approximately the same as the width of the groove 21a, is disposed adjacent the groove 21a circumferentially around the mirror 21. The inside diameter of the ring 22 is larger than the outside diameter of the mirror 21. Two O-rings 25 are disposed on the side-walls of the groove 21a so as to fill the gap between the groove 21a and the ring 22. The resulting annular space defined by the groove 21a, the two O-rings 25, and the ring 22 is filled with a static fluid 24. Holding members 23, made from stainless steel or Invar, are disposed at three points evenly spaced around the circumference of the ring 22.

Thus, the mirror 21 can be mounted vertically or in any other posture by the holding members 23.

The fluid 24 generally is a liquid or a gas as described above, and is static in this embodiment. According to Pascal's principle, the static pressure of the fluid 24 exerted on the groove 21a, O-rings 25, and ring 22 (pressure denoted in the figure by arrows) is the same at all points perpendicular to the surfaces of these components. Consequently, the entire circumference of the mirror 21 can be supported with a constant force being applied circumferentially to the mirror by the static pressure of the fluid 24 around the circumference of the mirror.

Since the holding members 23 in this embodiment support the mirror 21 at respective points on the circumference of the mirror, the contacted loci on the ring 22 that are being supported will experience irregular deformation. However, since the O-rings 25 are disposed on the side-walls of the groove 21a in the manner described above, whenever the ring 22 experiences such distortion, the contact locus is displaced radially toward the center of the mirror 21 along the side walls of the groove 21a. In other words, any radial stress exerted by the ring toward the center of the mirror 21 is manifest only as static pressure of the fluid 24, which prevents the mirror from experiencing the stress. The O-rings 25 are configured so as not to bind mirror 21.

Deformation of the ring 22 causes the pressure of the fluid 24 inside the groove 21a to increase slightly. This pressure is exerted uniformly as a radial compression around the entire circumference of the mirror 21. Whereas the mirror 21 can experience deformation as a result, the deformation is limited to an axially symmetrical deformation that is readily canceled my appropriate optical adjustments.

A mirror-holding method and device associated with a fourth representative embodiment is shown in FIG. 4. This embodiment is similar to the third representative embodiment except that, in the fourth embodiment, the fluid inside the groove is circulated.

The mirror-holding device shown in FIG. 4 is especially suitable for holding any of the mirrors in the illumination-optical system 217 and the projection-optical system 227, as well as the mirrors 219 and 221, shown in FIG 1.

By way of example, the mirror 31 shown in FIG. 4 is disc-shaped. The mirror 31 has a reflective surface (left-facing surface of the mirror shown in FIG. 2) that is concave, with a surface that is polished and formed, with extremely high accuracy, with an EUV-reflective multi-layer coating.

As in the third representative embodiment, the mirror 31 in the fourth embodiment has a groove 31a defined in the circumferential edge of the mirror 31. The groove 31 a has a defined depth and extends around the entire circumference of the mirror 31. A ring 32 of metal or the like, having a defined thickness and a width approximately the same as the width of the groove 31a, is disposed adjacent the groove 31a circumferentially around the mirror 31. The inside diameter of the ring 32 is larger than the outside diameter of the mirror 31. Two O-rings 35 are disposed on the side-walls of the groove 31 a so as to fill the gap between the groove 31 a and the ring 32. The resulting annular space defined by the groove 31a, the two O-rings 35, and the ring 32 is filled with a fluid 34. Holding members (not shown, but configured similarly to the holding members 23 used in the third representative embodiment) are disposed at three points evenly spaced around the circumference of the ring 32. Thus, the mirror 31 can be mounted vertically or in any other posture by the holding members.

In this embodiment, a first fluid port 32a is defined in the ring 32 and extends through the thickness of the ring (the port 32a is located at the top of the ring 32 in FIG. 4). A fluid-supply tube 36 is connected to the first fluid port 32a so as to supply the fluid 34 to the inside of the groove 31a. The tube 36 is connected to a heat-exchanger 37 that, in turn, is connected upstream to a fluid-supply (not shown) used for storing a supply of fluid 34. A second fluid port 32b also is defined in the ring 32 and extends through the thickness of the ring (the port 32b is located at the bottom of the ring 32 in FIG. 4). The second fluid port 32b is connected to a drain tube 38 that routes the fluid 34 from the groove 31 a to the fluid-supply (not shown, but is the same fluid-supply referred to above that supplies fluid to the heat-exchanger 37).

The temperature of the fluid 34 routed from the fluid-supply to the groove 31 a is regulated at a desired temperature by the heat-exchanger 37. In the groove 31a the fluid passes from the first fluid port 32a to the second fluid port 32b, thereby circulating in the groove around the circumference of the mirror 31.

In this embodiment, a slight pressure difference may exist between the first and second ports 32a, 32b, respectively, and thus between the "top" and "bottom" of the mirror 31. In response to this pressure difference, the mirror 31 may experience mild deformation from the corresponding unequal support pressure being applied to the mirror. To prevent or at least minimize such a pressure difference, the fluid 34 desirably is not compressible and desirably has low viscosity. For example, a candidate fluid meeting these criteria is water (having a viscosity of approximately 1×10⁻³ Pa·s).

The circulating fluid, as noted above, is temperature-regulated by the heat-exchanger 37. The temperature-controlled fluid effectively reduces the consequences of temperature changes of the mirror, which otherwise can experience a temperature increase from being irradiated by EUV radiation during normal use.

Whereas the invention is described in the context of multiple representative embodiments, it will be understood that the invention is not limited to those embodiments. On the contrary, the invention intended to encompass all modifications, alternatives, and equivalents as may be included within the spirit and scope of the invention, as defined by the appended claims.

## Claims

**1.** A method for holding an optical element in an optical system, comprising:
providing a fluid chamber containing a fluid and extending peripherally around the optical element; and
mounting the optical element to a holding member such that the fluid chamber is situated between the optical element and the holding member.

**2.** The method of claim 1, wherein:
the optical element has a circular edge; and
the step of providing the fluid chamber extending peripherally around the optical element comprises extending the fluid chamber circumferentially around the edge of the optical element.

**3.** The method of claim 1, wherein the step of providing a fluid chamber comprises providing an elastomeric fluid chamber.

**4.** The method of claim 1, wherein the step of providing the fluid chamber comprises defining the fluid chamber in a peripheral edge of the optical element.

**5.** The method of claim 4, wherein the step of defining the fluid chamber comprises:
defining a groove extending into the peripheral edge of the optical element;
extending a ring circumferentially around the peripheral edge of the optical element, the ring having a width sufficient to cover the groove; and
sealing the ring to the groove.

**6.** The method of claim 1, wherein the step of providing a fluid chamber containing a fluid comprises providing the fluid in a static condition in the fluid chamber.

**7.** The method of claim 1, further comprising the step of circulating the fluid in the fluid chamber.

**8.** The method of claim 7, including the step of controlling a temperature of the fluid as the fluid is being circulated in the fluid chamber.

**9.** The method of claim 1, wherein the fluid is a gas.

**10.** The method of claim 1, wherein the fluid is a liquid.

**11.** The method of claim 1, wherein the optical element is a reflective mirror.

**12.** The method of claim 1, wherein the optical element is an X-ray reflective mirror.

**13.** A device for holding an optical element in an optical system, comprising:
a fluid chamber extending peripherally around the optical element; and
a fluid situated in the fluid chamber;
wherein the optical element is mounted to a holding member of the optical system such that the fluid chamber is situated between the optical element and the holding member.

**14.** The device of claim 13, wherein:
the optical element has a circular edge; and
the fluid chamber extends circumferentially around the circular edge.

**15.** The device of claim 13, wherein the fluid chamber is elastomeric.

**16.** The device of claim 13, wherein the fluid chamber is defined in a peripheral edge of the mirror.

**17.** The device of claim 16, wherein the fluid chamber is defined as a groove extending into the peripheral edge of the mirror, the device further comprising a ring extending circumferentially around the peripheral edge of the mirror, the ring having a width sufficient to cover the groove, and the ring being sealed to the groove.

**18.** The device of claim 13, wherein the fluid in the chamber is static.

**19.** The device of claim 13, wherein the fluid in the chamber is circulated.

**20.** The device of claim 19, further comprising a heat-exchanger through which the fluid is circulated so as to remove heat from the fluid as the fluid is being circulated in the fluid chamber.

**21.** The device of claim 13, wherein the fluid is a gas.

**22.** The device of claim 13, wherein the fluid is a liquid.

**23.** The device of claim 13, wherein the optical element is a reflective mirror.

**24.** The device of claim 13, wherein the optical element is an X-ray reflective mirror.

**25.** In combination:
an X-ray reflective mirror configured for use as an optical element in an X-ray optical system; and
a device, as recited in claim 13, holding the X-ray reflective mirror.

**26.** An optical element mounted to a holding member, comprising:
a fluid chamber situated between the optical element and the holding member; and
a fluid situated in the fluid chamber.

**27.** The optical element of claim 26, wherein:
the optical element has a circular edge; and
the fluid chamber extends circumferentially around the circular edge.

**28.** The optical element of claim 26, wherein the fluid chamber is elastomeric.

**29.** The optical element of claim 26, wherein:
the optical element has a peripheral edge; and
the fluid chamber is defined in the peripheral edge.

**30.** The optical element of claim 29, wherein the fluid chamber is defined as a groove extending into the peripheral edge of the optical element.

**31.** The optical element of claim 30, further comprising a ring extending circumferentially around the peripheral edge, the ring having a width sufficient to cover the groove, and the ring being sealed to the groove.

**32.** The optical element of claim 26, wherein the fluid is static.

**33.** The optical element of claim 26, wherein the fluid is circulating.

**35.** The optical element of claim 33, further comprising a heat-exchanger through which the fluid is circulated so as to remove heat from the fluid as the fluid is circulated in the fluid chamber.

**36.** The optical element of claim 26, wherein the fluid is a gas.

**37.** The optical element of claim 26, wherein the fluid is a liquid.

**38.** The optical element of claim 26, configured as a reflective mirror.

**39.** The optical element of claim 26, configured as an X-ray reflective mirror.

**40.** An X-ray optical system, comprising a combination as recited in claim 25.

**41.** An X-ray optical system, comprising an optical element as recited in claim 26.

**42.** A microlithography system, comprising:
a beam source that generates a lithographic energy beam;
an illumination-optical system situated downstream of the beam source and configured to guide the energy beam from the beam source to a pattern-defining reticle, the illumination-optical system comprising at least one respective optical element and a holding member for the optical element;
a projection-optical system situated downstream of the reticle and configured to guide the energy beam from the reticle to a sensitive substrate so as to imprint the pattern on the sensitive substrate, the projection-optical system comprising at least one respective optical element and a holding member for the optical element; and
a chamber containing at least the illumination-optical system and projection-optical system;
wherein (i) the illumination-optical system further comprises a fluid chamber situated between the respective holding member and the respective optical element, (ii) the projection-optical system further comprises a fluid chamber situated between the respective holding member and the respective optical element, and (iii) a fluid is situated in each of the fluid chambers.

**43.** A microlithography system as recited in claim 42, wherein the energy beam is an X-ray beam.

**44.** A microlithography system as recited in claim 42, wherein the optical elements are respective mirrors reflective to the energy beam.
